# EUROPÄISCHE PATENTANMELDUNG

(11) **EP 4 160 900 A1**
(43) Veröffentlichungstag der Anmeldung: **05.04.2023**
(21) Anmeldenummer: 21199817.4
(22) Anmeldetag: 29.09.2021
(51) Int. Cl.: H02M 7/483, H02M 1/32, H02M 7/00, H01L 23/473, H05K 7/14

(54) **SUBMODUL MIT BREMSSTELLERFUNKTION FÜR EINEN MODULAREN MULTILEVEL-STROMRICHTER**

(71) Anmelder: Siemens Aktiengesellschaft, 80333 München (DE)
(72) Erfinder: Hofmann, Viktor, 95448 Bayreuth (DE); Hofstetter, Patrick, 91056 Erlangen (DE)
(74) Vertreter: Siemens Patent Attorneys

(57) **Zusammenfassung**

Die Erfindung betrifft ein Submodul (1) für einen modularen Multilevel-Stromrichter (2), wobei das Submodul (1) zwei Kondensatoren (3), zwei Widerstände (4) und sechs Halbleiterschalter (5,51,52,53,54,55,56) aufweist, wobei die zwei Kondensatoren (3) in Reihe angeordnet sind, wobei jeweils elektrisch parallel zu den Kondensatoren (3) zwei der Halbleiterschalter (5,51,52,53,54) in Reihe angeordnet sind, wobei ein Verbindungspunkt (60) in der Verbindung zwischen den zwei in Reihe angeordneten Halbleiterschaltern (5) jeweils einen Anschluss (11) des Submoduls (1) bildet. Zur Verbesserung hinsichtlich seines Bremsstellers eines aus Submodulen aufgebauten modularen Multilevel-Stromrichters (2) wird vorgeschlagen, dass jeweils zu den Kondensatoren (3) elektrisch parallel eine Reihenschaltung von einem der Widerstände (4) und einem der Halbleiterschalter (5,55,56) angeordnet ist. Ferner betrifft die Erfindung einen modularer Multilevel-Stromrichter (2), wobei der modulare Multilevel Stromrichter (2) Gleichspannungsanschlüsse (24) aufweist, wobei zwischen den Gleichspannungsanschlüssen (24) eine Vielzahl von derartigen Submodulen (1) elektrisch in Reihe angeordnet sind. Die Erfindung betrifft weiter ein Verfahren zum Betreiben eines derartigen Submoduls (1) oder eines derartigen modularen Multilevel-Stromrichters (2), wobei zur Umwandlung von elektrischer Energie in Wärme mindestens einer der zwei in einer Reihenschaltung mit einem der Widerstände (4) angeordneten Halbleiterschalter (5,55,56) getaktet oder geschaltet wird.

## Beschreibung

Die Erfindung betrifft ein Submodul für einen modularen Multilevel-Stromrichter, wobei das Submodul zwei Kondensatoren, zwei Widerstände und sechs Halbleiterschalter aufweist, wobei die zwei Kondensatoren in Reihe angeordnet sind, wobei jeweils elektrisch parallel zu den Kondensatoren zwei der Halbleiterschalter in Reihe angeordnet sind, wobei ein Verbindungspunkt in der Verbindung zwischen den zwei in Reihe angeordneten Halbleiterschaltern jeweils einen Anschluss des Submoduls bildet. Ferner betrifft die Erfindung einen modularen Multilevel-Stromrichter mit mindestens einem Phasenmodul, wobei das Phasenmodul zwei in Reihe angeordnete Konverterarme umfasst, wobei die Konverterarme jeweils eine Reihenschaltung einer Vielzahl von derartigen Submodulen aufweisen. Die Erfindung betrifft weiter ein Verfahren zum Betreiben eines derartigen Submoduls oder eines derartigen modularen Multilevel-Stromrichters.

Der modulare Multilevel-Stromrichter (M2C) ist eine Stromrichter-Topologie, die insbesondere für Mittel- und Hochspannungsanwendungen geeignet ist und zur Anwendung kommt. Der Grundaufbau des mehrphasigen Stromrichters weist zwei Konverterarme pro Phase in einem Phasenmodul auf, die jeweils als Serienschaltung zahlreicher Submodule ausgeführt sind. Im grundlegenden Aufbau kann mit dem Stromrichter Energie übertragen oder in einem gewissen Maß zwischengespeichert werden. Um zusätzlich einen gezielten Energieabbau zu ermöglichen, ist die Installation eines Braking Moduls, auch als Bremssteller bezeichnet, notwendig. Dieses Modul wird an dem Gleichspannungszwischenkreis, beispielsweise zwischen DC+ und DC-, angeschlossen und kann aus einer Serienschaltung zahlreicher Submodule und mindestens eines Widerstands aufgebaut werden.

Der Aufbau des modularen Multilevel-Stromrichters und die Anordnung sowie mögliche Ausgestaltung seiner Submodule ist aus der DE 101 03 031 A1 bekannt. Eine alternative Ausgestaltung von Submodulen ist in der WO 2007-025828 A1 offenbart.

Aus der WO 2007-023061 A2 ist der Aufbau eines Bremsstellers für einen modularen Multilevel-Stromrichter bekannt. Eine einfache Ausführungsform eines Braking Moduls ist durch eine Serienschaltung eines Schalters und einem Lastwiderstand mit einer Freilaufdiode gegeben. Die Sperrfähigkeit des Schalters richtet sich nach der Höhe der Spannung auf der Gleichspannungsseite des modularen Multilevel-Stromrichters. Alternativ als eine weitere Ausführungsform ist eine Reihenschaltung aus Submodulen und einem Lastwiderstand bekannt.

Das "Dokument Application of modular multilevel converter in medium voltage high power permanent magnet synchronous generator wind energy conversion systems" (M. Wang, Y. Hu, W. Zhao, Y. Wang, G. Chen, IET Journals, ISSN 1752-1416) beschreibt einen in einem Submodul angeordneten Bremswiderstand.

Unter dem Begriff in Reihe angeordnet, ist zu verstehen, dass die Spannung über den einzelnen Bauelementen sich zu einer Gesamtspannung über den in Reihe angeordneten Elementen addieren. Diese Bauelemente müssen dabei nicht notwendigerweise vom gleichen Strom durchflossen werden. Es kann sich dabei beispielsweise eine Verzweigung zwischen den in Reihe angeordneten Bauelementen befinden.

Der Erfindung liegt die Aufgabe zugrunde, Submodule für den Aufbau eines modularen Multilevel-Stromrichters mit Bremsstellerfunktion zu verbessern.

Diese Aufgabe wird durch ein Submodul für einen modularen Multilevel-Stromrichter gelöst, wobei das Submodul zwei Kondensatoren, zwei Widerstände und sechs Halbleiterschalter aufweist, wobei die zwei Kondensatoren in Reihe angeordnet sind, wobei jeweils elektrisch parallel zu den Kondensatoren zwei der Halbleiterschalter in Reihe angeordnet sind, wobei ein Verbindungspunkt in der Verbindung zwischen den zwei in Reihe angeordneten Halbleiterschaltern jeweils einen Anschluss des Submoduls bildet, wobei jeweils zu den Kondensatoren elektrisch parallel eine Reihenschaltung von einem der Widerstände und einem der Halbleiterschalter angeordnet ist. Ferner wird diese Aufgabe durch einen modularer Multilevel-Stromrichter gelöst, wobei der modulare Multilevel Stromrichter Gleichspannungsanschlüsse aufweist, wobei zwischen den Gleichspannungsanschlüssen eine Vielzahl von derartigen Submodulen elektrisch in Reihe angeordnet sind. Diese Aufgabe wird weiter durch ein Verfahren zum Betreiben eines derartigen Submoduls oder eines derartigen modularen Multilevel-Stromrichters gelöst, wobei zur Umwandlung von elektrischer Energie in Wärme mindestens einer der zwei in einer Reihenschaltung mit einem der Widerstände angeordneten Halbleiterschalter getaktet oder geschaltet wird.

Weitere vorteilhafte Ausgestaltungen der Erfindung sind in den abhängigen Ansprüchen angegeben.

Der Erfindung liegt unter anderem die Erkenntnis zugrunde, dass sich der Bremssteller dadurch verbessern lässt, dass der Bremswiderstand zur Umwandlung von elektrischer Energie im Submodul angeordnet ist. Bei einem sogenannten Doppelmodul, das mindestens drei oder mindestens vier Schaltzustände aufweist, ist es dabei besonders vorteilhaft, genau zwei Widerstände in dem Modul anzuordnen. Bei den genannten drei oder vier Schaltzuständen erzeugen diese unabhängig von der Stromflussrichtung des Stroms durch das Submodul eine unterschiedliche Spannung an den Anschlüssen des Submoduls. Die beiden Widerstände des Submoduls können identisch, insbesondere im Hinblick auf ihren Widerstandswert identisch, sein oder sich in ihrem Widerstandswert unterscheiden. Eine Anordnung mit unterschiedlichem Widerstandswert der beiden Widerstände erlaubt eine feinstufige Regelung der Energieumwandlung in Wärme durch das Submodul.

Der Aufbau des vorgeschlagenen Submoduls hat den besonderen Vorteil, zwei Funktionen, zum einen die Erzeugung einer Spannung an den Anschlussklemmen des Submoduls und zum anderen die Umwandlung von elektrischer Energie durch den Widerstand oder die Widerstände, unabhängig voneinander durchzuführen. Daher ist möglich, eine Vielzahl von Submodulen zwischen den Gleichspannungsanschlüssen in einer Reihenschaltung zu einem Bremssteller anzuordnen und mit Gleichspannungsanschlüssen des modularen Multilevel-Stromrichters zu verbinden. Diese Anordnung der Submodule für die Umwandlung für elektrische Energie in Wärme kann auch als Bremsstellermodul bezeichnet werden. Diese Schaltung erlaubt eine durch eine Regelvorrichtung gesteuerte oder geregelte Umwandlung von elektrischer Energie in Wärme. Gleichzeitig kann durch die beiden Widerstände unabhängig von der Umwandlung der elektrischen Energie in Wärme eine Symmetrierung der über den Kondensatoren anliegenden Spannungen vorgenommen werden. Die Funktionen Spannungserzeugung an den Anschlüssen und die Umwandlung elektrischer Energie sind in dem vorgeschlagenen Submodul entkoppelt.

Darüber hinaus ist es möglich, die Submodule in einem Phasenmodul anzuordnen. Dazu werden jeweils eine Vielzahl der vorgeschlagenen Submodule in Reihe zu einem Konverterarm verbunden. Vorteilhafterweise kann dieser Konverterarm zur Verbesserung der Regelungseigenschaften eine Induktivität umfassen. Zwei dieser Konverterarme bilden ein Phasenmodul. Dazu werden die beiden Konverterarme in Reihe zwischen den Gleichspannungsanschlüssen des modularen Multilevel-Stromrichters angeordnet. Eine Verbindungsstelle der beiden Konverterarme bildet einen Phasenanschluss des modularen Multilevel-Stromrichters. Da die vorgeschlagenen Submodule die Eigenschaft haben, die Funktionen Spannungserzeugung an den Anschlüssen des Submoduls und die Energieumwandlung in Wärme unabhängig voneinander anzuführen, kann mit den Submodulen ein Phasenmodul geschaffen werden, mit dem ein Phasenanschluss zur Versorgung einer Last zur Verfügung steht. Gleichzeitig kann unabhängig von der gesteuerten oder geregelten Versorgung der Last mit elektrischer Energie darüber hinaus elektrische Energie in Wärme umgewandelt werden. Durch diese Vereinigung zweier Funktionen in dem Phasenmodul kann auf ein zusätzliches und separates Bremsstellermodul zwischen den Gleichspannungsanschlüssen verzichtet werden. Dies macht den modularen Multilevel-Stromrichter nicht nur kostengünstig, sondern erlaubt es auch, diesen in geringen Abmessungen zur Verfügung zu stellen. Gerade im Mittelspannungsbereich, führt dies zu einer deutlichen Platzersparnis und geringer Baugröße eines so aufgebauten modularen Multilevel-Stromrichters, da aufgrund der Isolationsabstände die einzelnen Komponenten mit hinreichendem Abstand zueinander angeordnet werden müssen und damit Bauraum beanspruchen.

Zur Steuerung oder Regelung des Submoduls werden die Halbleiterschalter des Submoduls geschaltet. Das periodische Ein- und Ausschalten der Halbleiterschalter, beispielsweise mittels einer Pulsweitenmodulation, wird auch mit Takten bezeichnet. Dabei werden zur Erzeugung einer vorgebbaren Spannung an den Anschlüssen des Submoduls insgesamt vier der Halbleiterschalter, von denen jeweils zwei in Reihe und diese in Reihe angeordneten Halbleiterschalter darüber hinaus parallel zu einem der Kondensatoren angeordneten Halbleiterschalter geschaltet oder getaktet. Diese Halbleiterschalter werden auch als erster, zweiter, dritter und vierter Halbleiterschalter des Submoduls bezeichnet. Zur Steuerung oder Regelung der Energieumwandlung in Wärme wird jeweils der in der Reihenschaltung mit dem Widerstand angeordnete Halbleiterschalter geschaltet oder getaktet. Diese Halbleiterschalter zur Steuerung oder Regelung der Energieumwandlung in Wärme werden als fünfter und sechster Halbleiterschalter bezeichnet.

Der fünfte Halbleiterschalter und der sechste Halbleiterschalter können alternativ zu einer bidirektionalen Ausgestaltung mit einem Schaltelement und einer antiparallel zum Schaltelement angeordneten Diode auch unidirektional ausgebildet sein. Dabei umfasst der Halbleiterschalter nur ein Schaltelement und keine Diode. Der Halbleiterschalter ist dann diodenfrei ausgeführt. Dies ist dann möglich, wenn die Submodule in einem Bremsstellermodul angeordnet sind und dann im Betrieb nur ein positiver Strom durch die Submodule zum Tragen kommt. Gleichzeitig können, alternativ oder ergänzend, dann der erste, zweite, dritte und vierte Halbleiterschalter durch eine Diode ersetzt werden. Für ein Submodul, das in einem Bremsstellermodul angeordnet ist, können diese Ausgestaltungen miteinander kombiniert werden.

Mit dem vorgeschlagenem Submodul kann auch die Symmetrierung der an den Kondensatoren anliegenden Spannungen auf einfache Weise durch Zuschalten des entsprechenden Halbleiterschalters verlustarm durchgeführt werden.

Bei einer vorteilhaften Ausgestaltung der Erfindung sind die zwei in einer Reihenschaltung mit einem der Widerstände angeordneten Halbleiterschalter als ein Halbbrückenmodul ausgebildet, wobei der Phasenanschluss des Halbbrückenmoduls mit einem weiteren Verbindungspunkt in der Verbindung zwischen den zwei Kondensatoren verbunden ist. Halbbrückenmodule sind zur Realisierung von Phasen in einem Stromrichter als bauliche Einheit verfügbar. Diese Einheit kann auch für die Bildung des Submoduls genutzt werden. Es hat sich herausgestellt, dass ein Großteil der für eine Stromrichterphase vorhandenen Schutzfunktionen, wie beispielsweise eine Überwachung auf einen Überstrom, d.h. einen Schutz vor einem unzulässig hohen Strom, auch für den Schutz der Halbleiterschalter des Submoduls, die in Reihe und parallel zu einem der Kondensatoren angeordnet sind, genutzt werden können und auch den Betrieb des Submoduls nicht wesentlich beeinträchtigen oder sogar unmöglich machen. So können diese Halbbrückenmodule unter Verwendung eines Großteils der bestehenden Schutzfunktionen auch für den Einsatz im Submodul verwendet werden. Dadurch weist das Submodul zahlreiche Gleichteile auf, die auch eine Wartung besonders kostengünstig macht, da die Ersatzteilhaltung entsprechend aufwandsarm ist. Zudem ist das Submodul durch den Einsatz erprobter und vielseitig genutzter Komponenten besonders zuverlässig.

Bei einer weiteren vorteilhaften Ausgestaltung der Erfindung werden die in Reihe und gleichzeitig parallel zum Kondensator angeordneten Halbleiterschalter jeweils durch ein weiteres Halbbrückenmodul gebildet, wobei der Phasenanschluss des Weiteren Halbbrückenmoduls den Anschluss des Submoduls bildet. Wie oben ausgeführt sind Halbbrückenmodule zur Realisierung von Phasen in einem Stromrichter als bauliche Einheit verfügbar. Diese Einheit kann auch für die Bildung des Submoduls genutzt werden. Es hat sich herausgestellt, dass die für eine Stromrichterphase vorhandenen Schutzfunktionen, wie beispielsweise ein Schutz vor einem Zwischenkreiskurzschluss, auch für den Schutz der Halbleiterschalter des Submoduls, die mit dem Widerstand jeweils in einer Reihenschaltung angeordnet sind, genutzt werden können und auch den Betrieb des Submoduls nicht beeinträchtigen oder sogar unmöglich machen. So können diese Halbbrückenmodule unter Verwendung bestehender Schutzfunktionen auch für den Einsatz im Submodul verwendet werden. Dadurch weist das Submodul eine Vielzahl von Gleichteilen auf, die auch eine Wartung besonders kostengünstig macht, da die Ersatzteilhaltung entsprechend aufwandsarm ist. Zudem ist das Submodul durch den Einsatz erprobter und vielseitig genutzter Komponenten besonders zuverlässig.

Bei einer weiteren vorteilhaften Ausgestaltung der Erfindung weist das Submodul einen Kühlpfad auf, der sich entlang der Halbleiterschalter und der Widerstände erstreckt. Aufgrund der Vielzahl der Widerstände in dem Stromrichter fallen auch in jedem einzelnen Widerstand des modularen Multilevel-Stromrichters im Vergleich zu einer Anordnung mit nur einem Bremswiderstand in dem Stromrichter nur ein Bruchteil der elektrischen Verluste an. Diese relativ geringen Verluste pro Widerstand lassen sich auf einfache Weise durch die Kühlung des Submoduls abführen. Dazu hat es sich als vorteilhaft erwiesen, wenn die zu kühlenden Komponenten des Submoduls, insbesondere die Halbleiterschalter und die Widerstände, in einem Kühlpfad angeordnet sind und von einem Kühlmittel entwärmt werden. Dabei nimmt das Kühlmittel, wie beispielsweise Luft oder Flüssigkeit, Wärme aus den Komponenten auf, so dass diese gekühlt werden. Dabei hat es sich als vorteilhaft erwiesen, den Kühlpfad derart auszugestalten, dass das Kühlmittel zuerst die Halbleiterschalter kühlt und dann die Widerstände. Damit ist aufgrund der an den Halbleiterschaltern und den Widerstanden im Betrieb entstehenden Temperaturen eine besonders gleichmäßige Kühlung erzielbar. Es hat sich gezeigt, dass sich diese Art der Kühlung dann besonders positiv auf die Lebensdauer des Submoduls auswirkt und sich damit eine hohe Lebensdauer erzielen lässt.

Bei einer weiteren vorteilhaften Ausgestaltung der Erfindung weist der modulare Multilevel-Stromrichter mindestens ein Phasenmodul auf, wobei das Phasenmodul zwei in Reihe angeordnete Konverterarme umfasst, wobei die Konverterarme jeweils eine Reihenschaltung einer Vielzahl der Submodule aufweisen, wobei die Verbindung zwischen den zwei Konverterarmen mit einem Phasenanschluss des modularen Multilevel-Stromrichters elektrisch leitend verbunden ist. Die Submodule sind in einem modularen Multilevel-Stromrichter sowohl für die Verwendung in einem separaten Bremsstellermodul als auch in den einem Phasenmodul geeignet. Durch die Verwendung in einem Phasenmodul kann die Eigenschaft, eine Spannung an den Anschlüssen des Submoduls unabhängig von der Bremsstellerfunktion zu erzeugen besonders vorteilhaft genutzt werden. Mit den in Reihe und parallel zu dem jeweiligen Kondensator angeordneten Halbleiterschaltern, also dem ersten, zweiten, dritten und vierten Halbleiterschalter, kann an den Anschlüssen des Submoduls eine Spannung erzeugt werden, die eine an den Phasenanschlüssen vorgegebene Spannung bewirkt. Somit kann die Spannung an dem Phasenanschluss auf einfache Weise durch eine Regelvorrichtung des modularen Multilevel-Stromrichters erzeugt werden. Darüber hinaus kann unabhängig von der Spannung am Phasenanschluss Energie durch Schalten des fünften und sechsten Halbleiterschalters in Wärme umgewandelt werden. Diese Umwandlung kann ebenfalls durch die Regelvorrichtung des modularen Multilevel-Stromrichters beispielweise geregelt oder gesteuert erfolgen. Damit kann das vorgeschlagene Submodul seine Eigenschaften der von einem Bremsstellerbetrieb unabhängigen Erzeugung einer Spannung an den Anschlüssen des Submoduls besonders vorteilhaft bei der Anordnung der Submodule in einem Phasenmodul zur Geltung bringen. Auf den Einsatz eines separaten Bremsstellermoduls kann verzichtet werden. Das reduziert nicht nur die Anzahl der Bauteile im erheblichen Maße, sondern führt auch zu einem platzsparenden Aufbau des modularen Multilevel-Stromrichters mit Bremsstellerfunktion. Durch die vergleichsweise geringe Anzahl von Bauteilen weist dieser Stromrichter auch eine besonders hohe Zuverlässigkeit auf.

Bei einer weiteren vorteilhaften Ausgestaltung der Erfindung weist der modulare Multilevel-Stromrichter genau drei Phasenmodule aufweist. Ein dreiphasiger modularer Multilevel-Stromrichter mit den vorgeschlagenen Submodulen in den drei Phasenmodulen hat sich als besonders vorteilhaft erwiesen. Damit können auch große dreiphasige Lasten mit elektrischer Energie versorgt werden, während sich eine in Wärme umzuwandelnde Energie auf noch mehr Widerstände verteilt. Die Wärmeentwicklung jedes einzelnen Widerstands reduziert sich dadurch nochmals erheblich. Dadurch ist die Anbindung des Widerstandes an das Kühlsystem und dem Kühlpfad des Submoduls noch einfacher möglich. Die Submodule können dadurch noch einmal kompakter aufgebaut werden. Eine Wärmestrahlung innerhalb des Moduls wird durch die geringere Temperatur der einzelnen Widerstände weitgehend vermieden. Die dadurch entstehende geringere Temperatur im Innern des Submoduls erhöht wiederum die Lebensdauer der darin befindlichen Komponenten und damit die Lebensdauer des gesamten Submoduls und eines daraus aufgebauten modularen Multilevel-Stromrichters.

Bei einer weiteren vorteilhaften Ausgestaltung der Erfindung werden die zwei in einer Reihenschaltung mit einem der Widerstände angeordneten Halbleiterschalter derart getaktet oder geschaltet, dass sich die an den Kondensatoren anliegenden Spannungen annähern oder identisch sind. Durch die zwei Widerstände und die zwei Kondensatoren in einem Submodul ist es neben der Umwandlung von elektrischer Energie in Wärme auch und sogar zusätzlich möglich, die Spannungen an den Kondensatoren unabhängig voneinander zu beeinflussen. Um die Spannung an dem Kondensator zu reduzieren, wird der parallel dazu in Reihenschaltung mit dem Widerstand angeordnete Halbleiterschalter eingeschaltet oder getaktet. Je länger der entsprechende Halbleiterschalter eingeschaltet ist, desto mehr verringert sich die Spannung an dem jeweiligen Kondensator, der parallel zu dieser Reihenschaltung aus Widerstand und dem entsprechenden Halbleiterschalter angeordnet ist. Dieser Effekt kann dazu genutzt werden, bei ungleichen Spannungen der Kondensatoren, den Kondensator mit der höheren Spannung durch ein entsprechend langes Einschalten des zugehörigen Halbleiterschalters derart zu verringern, dass sich diese Spannung der Spannung des anderen Kondensators annähert. Diese Annäherung kann insbesondere so lange erfolgen, bis die beiden Kondensatorspannungen identisch sind. Auf diese Weise lassen sich unabhängig von der Funktion der Bereitstellung einer Spannung an den Anschlüssen des Submoduls und der Energieumwandlung in Wärme, gleichzeitig die Spannungen an den Kondensatoren des Submoduls symmetrieren. Dies verleiht den aus diesen Submodulen aufgebauten modularen Stromrichter eine hohe Stabilität im Betrieb und ein hohes dynamisches Verhalten.

Im Folgenden wird die Erfindung anhand der in den Figuren dargestellten Ausführungsbeispiele näher beschrieben und erläutert. Es zeigen:
- FIG 1: eine Ausgestaltung eines Submoduls,
- FIG 2: Schaltzustände des Submoduls,
- FIG 3: eine weitere Ausgestaltung des Submoduls,
- FIG 4: eine Ausgestaltung eines modularen Multilevel-Stromrichters
- FIG 5: ein Ausführungsbeispiel eines bekannten Submoduls
- FIG 6: eine weitere Ausgestaltung des modularen Multilevel-Stromrichters,
- FIG 7: eine weitere Ausgestaltung des Submoduls und
- FIG 8: eine Ausführungsbeispiel für die Kühlung des Submoduls.

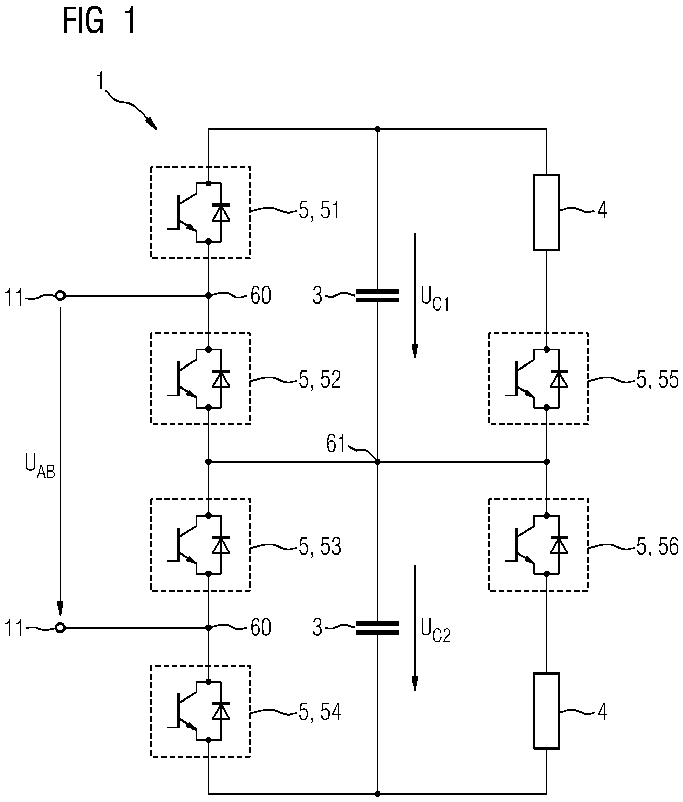

Die FIG 1 zeigt ein Ausführungsbeispiel eines vorgeschlagenen Submoduls 1 für einen modularen Multilevel-Stromrichter 2. Dieses Submodul 1 weist sechs Halbleiterschalter 5, zwei Kondensatoren 3 und zwei Widerstände 4 auf. Darüber hinaus weist das Submodul 1 Anschlüsse 11 auf, mit denen eine Vielzahl von Submodulen 1 innerhalb eines hier nicht dargestellten modularen Multilevel-Stromrichter 2 miteinander elektrisch verbunden werden. Die an den Anschlüssen 11 des Submoduls 1 anliegende Spannung wird mit U_{AB} bezeichnet. Die zwei Kondensatoren 3 sind in Reihe angeordnet. Dabei müssen sie nicht notwendigerweise vom gleichen Strom durchflossen werden, da der Strom zwischen den beiden in Reihe angeordneten Kondensatoren 3 sich verzweigen kann. Parallel zu einem ersten der zwei Kondensatoren 3 sind ein erster Halbleiterschalter 51 der Halbleiterschalter 5 und ein zweiter Halbleiterschalter 52 der Halbleiterschalter 5 in Reihe angeordnet. In der Verbindung zwischen dem ersten Halbleiterschalter 51 und dem zweiten Halbleiterschalter 52 liegt ein Verbindungspunkt 60. Dieser Verbindungspunkt 60 ist elektrisch mit dem Anschluss 11 verbunden und bildet somit den Anschluss 11 des Submoduls 1. Entsprechendes gilt für einen zweiten der Kondensatoren 3. Parallel zu dem zweiten der zwei Kondensatoren 3 sind ein dritter Halbleiterschalter 53 der Halbleiterschalter 5 und ein vierter Halbleiterschalter 54 der Halbleiterschalter 5 in Reihe angeordnet. In der Verbindung zwischen dem dritten Halbleiterschalter 53 und dem vierten Halbleiterschalter 54 liegt ebenfalls ein Verbindungspunkt 60. Dieser Verbindungspunkt 60 ist auch elektrisch mit einem Anschluss 11 verbunden und bildet somit den Anschluss 11 des Submoduls 1. Daraus ergeben sich zwei Anschlüsse 11 für das Submodul 1.

In der Verbindung zwischen den zwei Kondensatoren liegt ein weiterer Verbindungspunkt 61. Dabei ist der weitere Verbindungspunkt 61 elektrisch verbunden mit einer Verbindung, die den zweiten Halbleiter 53 und den vierten Halbleiter 54 miteinander verbindet.

Weiter ist parallel zum ersten der Kondensatoren 3 eine Reihenschaltung aus einem der Widerstände 4 und einem fünften Halbleiterschalter 55 der Halbleiterschalter 5 angeordnet. Analog dazu ist parallel zum zweiten der Kondensatoren 3 eine Reihenschaltung aus einem weiteren der Widerstände 4 und einem sechsten Halbleiterschalter 56 der Halbleiterschalter 5 angeordnet. Dieser zweite Funktionsteil, der die Widerstände 4 sowie den fünften Halbleiterschalter 55 und den sechsten Halbleiterschalter 56 umfasst, ermöglicht den gezielten, d.h. gesteuerten oder geregelten Energieabbau mit Hilfe des fünften Halbleiterschalters 55 und des sechsten Halbleiterschalters 56. Unter Energieabbau ist eine Umwandlung von elektrischer Energie in Wärme zu verstehen. Es wird also elektrische Energie abgebaut. Durch Einschalten des fünften Halbleiterschalters wird ein erster der Kondensatoren 3 über einen ersten der Widerstände 4 entladen. Entsprechendes gilt für einen zweiten der Kondensatoren 3, einen zweiten der Widerstände 4 und den sechsten Halbleiterschalter 56. Der Energieinhalt der Kondensatoren 3 bzw. die umgesetzte Leistung in den Widerständen 4, die auch als Lastwiderstände bezeichnet werden, kann so stets unabhängig von der Spannung an den Anschlüssen 11 des Submoduls 1 gesteuert oder geregelt werden. Damit ist eine Entkopplung zwischen der Spannungsmodulation durch den ersten, zweiten, dritten und vierten Halbleiterschalter 51, 52, 53, 54 und der Umwandlung elektrischer Energie in Wärme durch den fünften und sechsten Halbleiterschalter 55, 56 gegeben. Die ersten, zweiten, dritten und vierten Halbleiterschalter 51, 52, 53, 54 lassen sich unabhängig vom fünften und sechsten Halbleiterschalter 55, 56 betreiben und regeln.

Die Spannung über den Kondensatoren 3 wird mit U_{C1} bzw. U_{C2} bezeichnet.

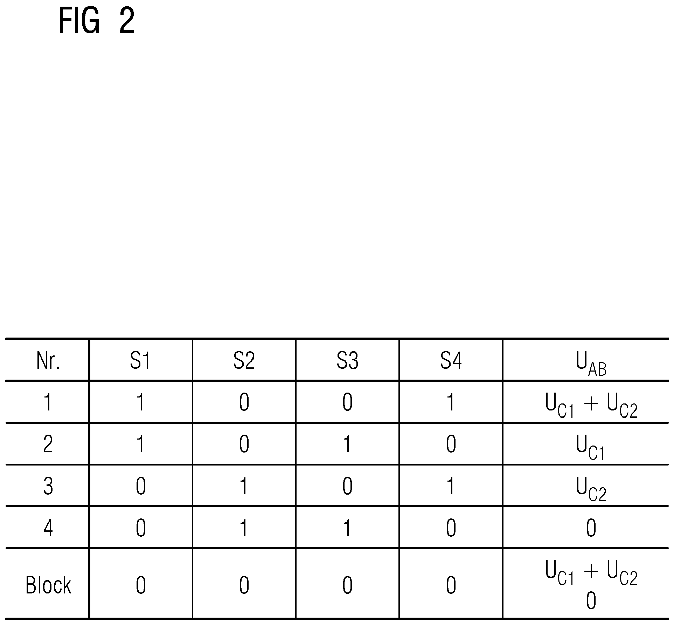

Die FIG 2 gibt in einer Tabelle die Spannung U_{AB} an den Anschlüssen 11 des Submoduls in Abhängigkeit vom Schaltzustand Sx der entsprechenden Halbleiterschalter 51, 52, 53, 54 an. Eine 1 kennzeichnet den eingeschalteten Zustand des entsprechenden Halbleiterschalters, eine 0 den ausgeschalteten. Dabei existieren vier unterschiedliche Schaltzustände des Submoduls (Spalte Nr), bei denen unabhängig von der Stromflussrichtung durch das Modul im allgemeinen unterschiedliche Spannungen an den Anschlüssen 11 erzeugt werden können. Diese kommen für den Betrieb des modularen Multilevel-Stromrichters 2 zum Einsatz. Im Fall, dass alle der ersten vier Halbleiterschalter 51, 52, 53, 54 ausgeschaltet sind, ergibt sich je nach Leitfähigkeit der Dioden eine von der Stromflussrichtung abhängige Spannung an den Anschlüssen 11 des Submoduls. Weitere Schaltzustände sind nicht zulässig, da diese einen Kurzschluss mindestens eines der Kondensatoren 3 bewirken würden.

Die beschriebenen Schaltzustände des Submoduls können genutzt werden, um eine Vielzahl von in Reihe angeordneten Submodulen 1 eines modularen Multilevel-Stromrichters 2, derart anzusteuern, dass an Phasenanschlüssen 23 des später näher beschriebenen modularen Multilevel-Stromrichters 2 eine vorgebbare Spannung erzeugt werden kann. Dabei kann mit dem modularen Aufbau des Submoduls 1 an dessen Anschlüssen 11 eine gewünschte Spannungsform quantisiert nachgebildet werden, indem mit den Submodulen 1 eine diskrete Spannung oder ein Klemmenkurzschluss moduliert wird.

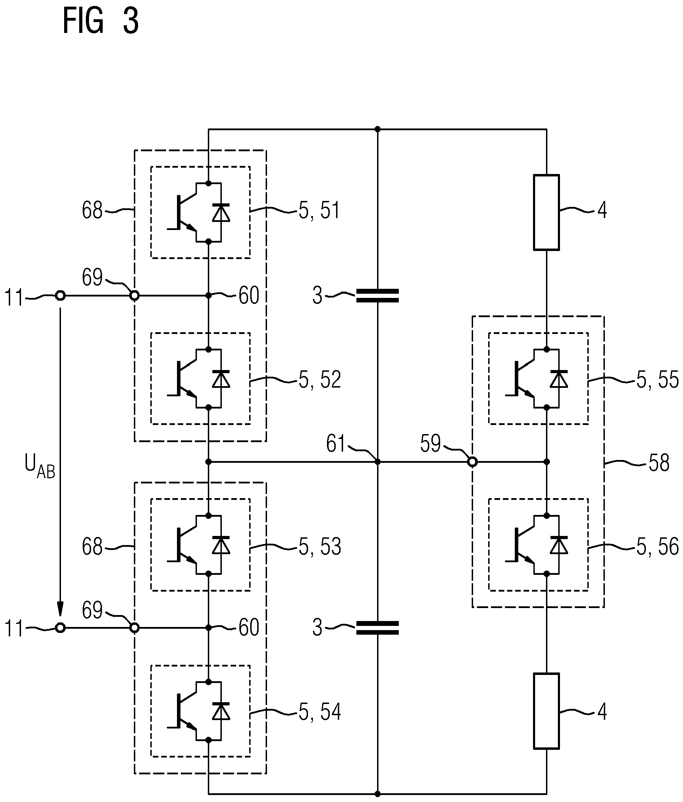

Die FIG 3 zeigt eine vorteilhafte Ausgestaltung des Submoduls 1. Zur Vermeidung von Wiederholungen wird auf die Beschreibung zur FIG 1 sowie auf die dort eingeführten Bezugszeichen verwiesen. Dabei ist der fünfte Halbleiterschalter 55 und der sechste Halbleiterschalter 56 in einer baulichen Einheit, einem Modul angeordnet. Derartige Module werden zum Aufbau eines Stromrichters in Zweipunkttechnologie verwendet und auch als Halbbrückenmodul bezeichnet. Ein derartiges Halbbrückenmodul 58 wird verwendet, um in dem vorgeschlagenem Ausführungsbeispiel den fünften und sechsten Halbleiterschalter 55, 56 zu realisieren. Ein Phasenanschluss 59 des Halbbrückenmoduls 58 wird dazu mit dem weiteren Verbindungspunkt 61 verbunden. Die zwei weiteren Anschlüsse des Halbbrückenmoduls 58 werden jeweils mit einem der Widerstände verbunden, so dass eine Reihenschaltung aus einem der Widerstände 4 und einem der Halbleiter 5 entsteht.

Alternativ oder ergänzend können auch die Teile oder alle der ersten, zweiten, dritten und vierten Halbleiterschalter durch weitere Halbbrückenmodule 68 realisiert werden. Dabei werden beispielsweise der erste Halbleiterschalter 51 und der zweite Halbleiterschalter 52 durch ein weiteres Halbbrückenmodul 68 gebildet. Analog kann, wie dargestellt, auch der der dritte Halbleiterschalter 53 und der vierte Halbleiterschalter 54 durch ein weiteres Halbbrückenmodul 68 gebildet werden, so dass sich für die vier Halbleiter 51, 52, 53, 54 zwei weitere Halbbrückenmodule 68 ergeben. Dabei ist der Phasenanschluss 69 des weiteren Halbbrückenmoduls 58 jeweils mit einem der Anschlüsse 11 elektrisch verbunden und bildet somit jeweils einen Anschluss 11 des Submoduls 1.

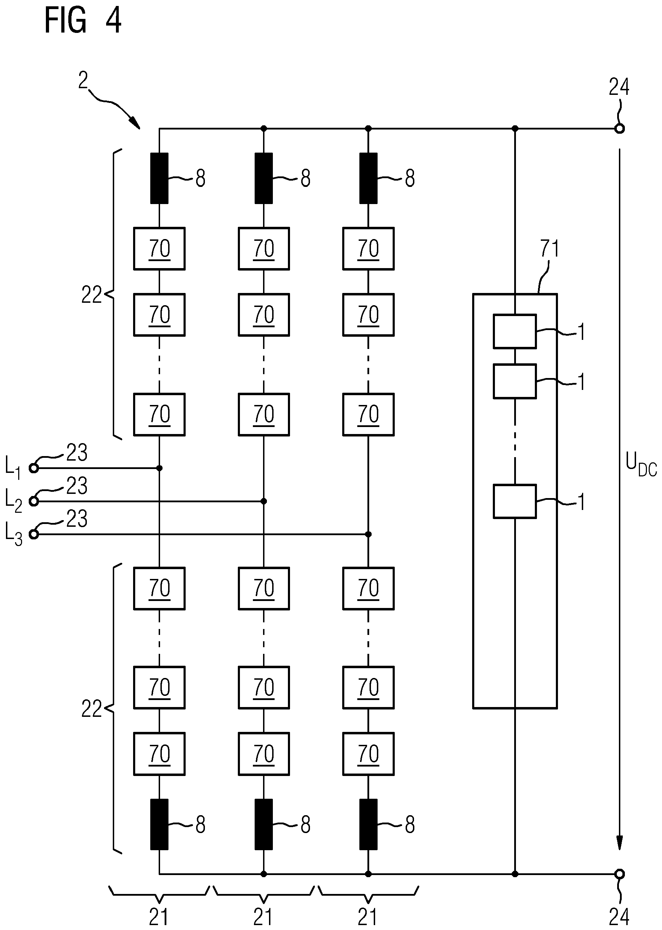

Die FIG 4 zeigt ein Ausführungsbeispiel eines modularen Multilevel-Stromrichters 2 mit Bremsstellerfunktion. Das bedeutet, dass es mit diesem Stromrichter möglich ist, elektrische Energie in Wärme umzusetzen. Diese Eigenschaft kann in vorteilhafter Weise dazu genutzt werden, ein an den Stromrichter angeschlossenes Energieversorgungsnetz zu stabilisieren oder überschüssige Energie, beispielsweise aus einem Bremsvorgang eines Antriebs, verschleißfrei aufzunehmen. In dem vorliegenden Ausführungsbeispiel sind dazu die vorgeschlagenen Submodule 1 in einer Reihenschaltung angeordnet und bilden ein Bremsstellermodul 71, das elektrisch mit den Gleichspannungsanschlüssen 24 des modularen Multilevel-Stromrichters 2 verbunden ist. An diesem Bremsstellermodul 71 liegt die Gleichspannung U_{DC} an, die auch als Zwischenkreisspannung bezeichnet wird.

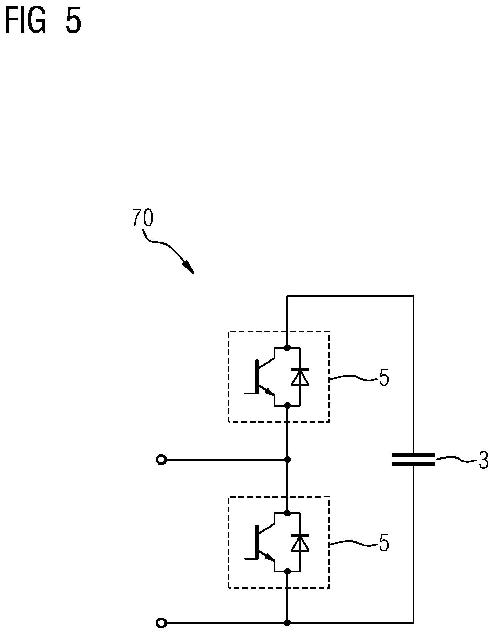

Die Phasenanschlüsse 23 des modularen Multilevel-Stromrichters 2 werden über die Phasenmodule 21 des modularen Multilevel-Stromrichters 2 gebildet. Dazu werden für ein Phasenmodul 21 zwei Konverterarme 22 in Reihe angeordnet. Der Verbindungspunkt dieser beiden Konverterarme 22 stellt einen Phasenanschluss 23 dar. Der modulare Multilevel-Stromrichter 2 kann dabei einphasig ausgebildet sein und weist dann ein oder zwei Phasenmodule 21 auf. Alternativ, wie dargestellt, kann der modulare Multilevel-Stromrichter 2 auch dreiphasig ausgebildet sein und weist dann drei Phasenmodule 21 zur Bildung der Phasen L₁, L₂ und L₃ auf. Die Konverterarme 22 werden durch eine Vielzahl von in Reihe angeordneten Submodulen 1,70 gebildet. Dafür können bereits bekannte Submodule 70 genutzt werden oder alternativ auch die vorgeschlagenen Submodule 1. Ein bekanntes Submodul 70 zeigt FIG 5. Da in dem vorliegenden Ausführungsbeispiel eine Bremsstellerphase mit dem Bremsstellermodul 71 vorhanden ist, können die einfach aufgebauten und bekannten Submodule 70 genutzt werden. Dieser Aufbau bietet sich insbesondere dann an, wenn ein bestehender modularer Multilevel-Stromrichter 2 um die Funktion eines Bremsstellers erweitert werden soll. Die Kombination des Bremsstellermoduls 71 mit den vorgeschlagenen Submodulen 1 bietet sich dann an, wenn hohe Energien in Wärme umzuwandeln sind. In diesem Fall kann die Anzahl der hier nicht dargestellten Widerstände 4 durch die Verwendung der vorgeschlagenen Submodule 1 deutlich erhöht werden. Dabei fällt die entstehende Wärme verteilt im System an und kann besonders einfach, beispielsweise durch die Einbindung der Widerstände 4 in ein Kühlsystem der einzelnen Submodule 1 abgeführt werden.

Zur Verbesserung der Regeleigenschaften von Strömen und/oder Spannungen des modularen Multilevel-Stromrichters 2 hat es sich als vorteilhaft erwiesen, in den Konverterarmen 22 jeweils eine Induktivität 8 anzuordnen.

Die FIG 5 zeigt ein bekanntes Submodul 70, das sich für die Anordnung in dem Phasenmodul 21 des modularen Multilevel-Stromrichters 2 gemäß dem Ausführungsbeispiel der FIG 4 eignet. Dieses weist dieses zwei Halbleiterschalter 5 und einen Kondensator 3 auf.

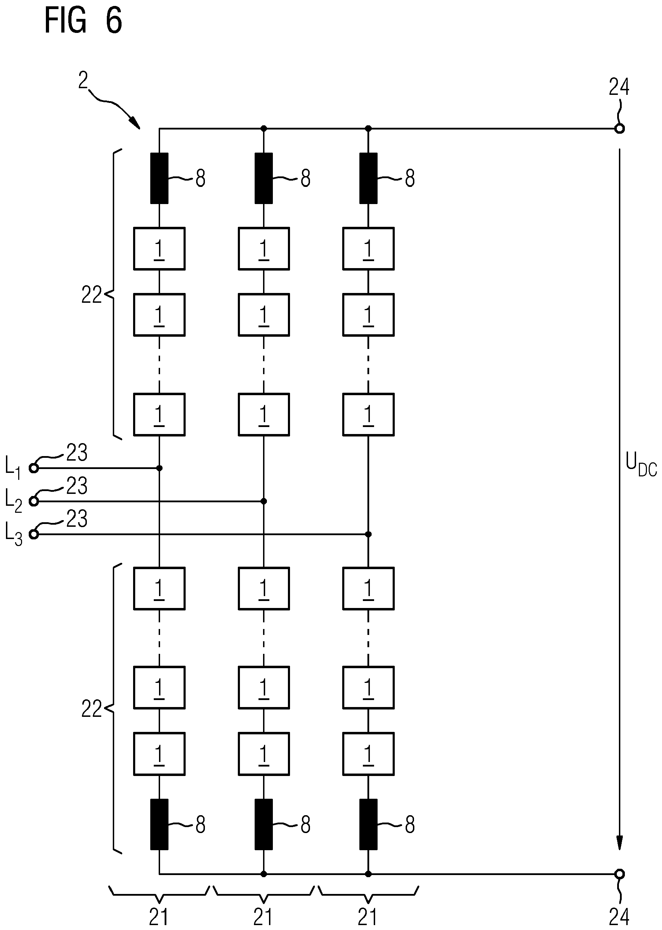

Die FIG 6 zeigt ein weiteres Ausführungsbeispiel eines modularen Multilevel-Stromrichters 2. Dabei sind in den Konverterarmen 22 eine Vielzahl der vorgeschlagenen Submodule 1 in Reihe angeordnet. Zur Vermeidung von Wiederholungen wird auf die Beschreibung zu den Figuren 1 bis 4, sowie auf die dort eingeführten Bezugszeichen verwiesen. Dieser modularer Multilevel-Stromrichter 2 weist ebenfalls eine Bremsstellerfunktion auf. Dafür ist jedoch kein Bremsstellermodul 71 erforderlich, sondern die Umwandlung der elektrischen Energie in Wärme erfolgt über die in den Submodulen 1 angeordneten Widerstände 4 des Phasenmoduls 21. Mit anderen Worten ist der modulare Multilevel-Stromrichter 2 in diesem Ausführungsbeispiel bremsstellermodulfrei ausgebildet. Auch dieser Stromrichter kann mit einem oder zwei Phasenmodulen 21 einphasig oder bei Verwendung von drei Phasenmodulen 21 dreiphasig ausgebildet sein. Die Phasenmodule 21 werden durch zwei in Reihe angeordnete Konverterarme 22 gebildet, wobei der Verbindungspunkt der beiden Konverterarme 22 jeweils den Phasenanschluss 23 des modularen Multilevel-Stromrichters 2 darstellt. Die Phasenmodule 21 sind zwischen den Gleichspannungsanschlüssen 24 des modularen Multilevel-Stromrichters 2 angeordnet, zwischen denen die Gleichspannung U_{DC} anliegt. Auch für diesen Aufbau hat es sich zur Verbesserung der Regeleigenschaften von Strömen und/oder Spannungen des Stromrichters als vorteilhaft erwiesen, jeweils eine Induktivität 8 in den Konverterarmen 22 anzuordnen.

Optional kann auch dieser modulare Multilevel-Stromrichter 2 um ein Bremsstellermodul 71 erweitert werden. Dazu kann ein bereits bekanntes Bremsstellermodul oder auch ein Bremsstellermodul 71 gemäß FIG 4 zwischen den Gleichspannungsanschlüssen 24 angeordnet werden.

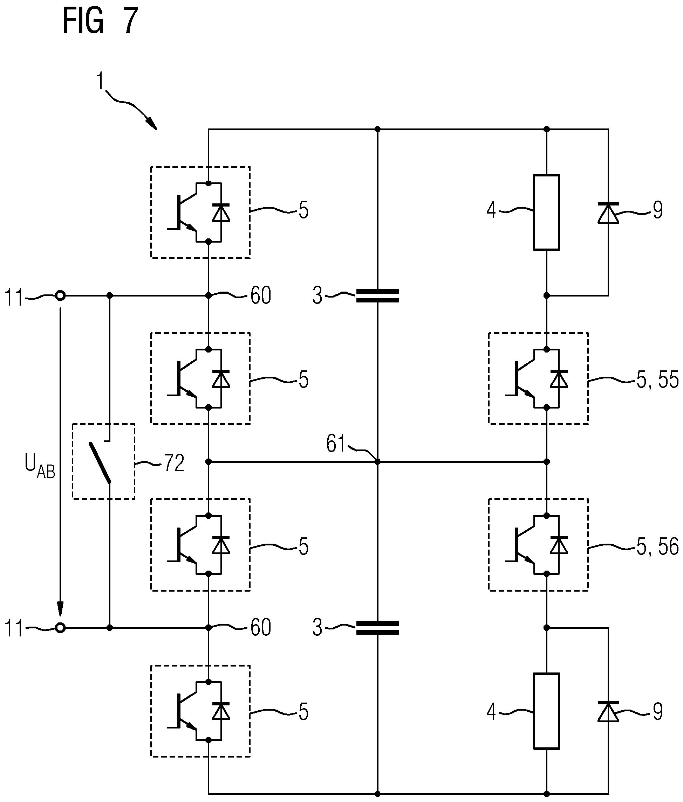

Die FIG 7 zeigt ein weiteres Ausführungsbeispiel des Submoduls 1. Zur Vermeidung von Wiederholungen wird auf die Beschreibung zu den Figuren 1 bis 3, sowie auf die dort eingeführten Bezugszeichen verwiesen. Dabei ist parallel zum Widerstand 4 jeweils eine Diode 9 angeordnet. Diese Dioden 9 reduzieren die im Betrieb des Submoduls 1 entstehenden Belastungen des fünften Halbleiterschalters 55 und des sechsten Halbleiterschalters 56. Dadurch ist es möglich, die Widerstände 4 nicht induktivitätsarm auszuführen, sondern sie können auch ein beliebiges induktives Verhalten aufweisen. Mit anderen Worten können die Widerstände 4 induktivitätsbehaftet sein. Des Weiteren ist es möglich, die Widerstände 4 in räumlicher Entfernung zu den übrigen Komponenten des Submoduls 1 anzuordnen. Vorteilhaft in diesem Zusammenhang ist beispielsweise eine Anordnung der Widerstände 4 außerhalb des Schaltschranks, um so die Kühlung der Submodule 1 bzw. des Schaltschranks zu vereinfachen, indem die Widerstände 4 als Wärmequelle entfernt angeordnet sind. Dabei können die Widerstände 4 beispielsweise mit einer induktivitätsbehafteten Kabelanordnung verbunden werden. Sogar Kabel mit einer Länge von über 10m oder über 100m sind realisierbar, so dass die Widerstände 4 auch im Freien angeordnet werden können. Auch bei diesen Kabellängen kann der negative Effekt auf das Schaltverhalten der Halbleiterschalter durch die vorhandene Induktivität des Kabels mittels der Dioden 9 eliminiert werden.

Alternativ oder ergänzend kann das Submodul an seinen Anschlüssen 11 einen Bypass 72 aufweisen. Dabei handelt es sich um einen Schalter, der im Falle einer Fehlfunktion des Submoduls 1, insbesondere eines oder mehrerer fehlerhaften oder ausgefallenen Halbleiterschalter 5, das Submodul 1 überbrückt und es dadurch aus der Vielzahl der in einer Reihenschaltung angeordneten Submodule 1 in seiner Wirkung herausnimmt.

Auch in diesem Ausführungsbeispiel können die Halbleiterschalter 5 durch ein oder mehrere Halbbrückenmodule 58, 68 realisiert werden.

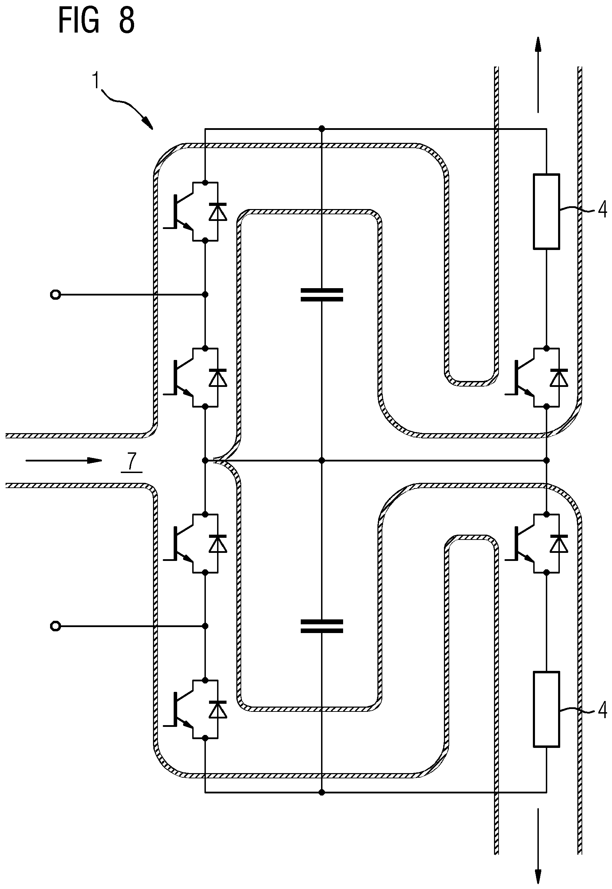

Die FIG 8 zeigt schematisch eine vorteilhafte Kühlung des Submoduls. Dabei ist ein Kühlpfad 7 zu erkennen. Dieser erstreckt sich über die Halbleiterschalter 5 und die Widerstände 4 des Submoduls 1 hinweg. Die Fließrichtung des Kühlmittels ist durch einen Pfeil angegeben. Dabei ist es vorteilhaft, wenn durch das Kühlmittel zunächst die Halbleiterschalter 5 gekühlt werden und anschließend dem Widerstand 4 zugeführt wird. Da die Widerstände 4 im Betrieb eine höhere Temperatur aufweisen, können durch diesen Aufbau, sowohl die Halbleiterschalter 5 als auch die Widerstände 4 wirkungsvoll und aufwandsarm gekühlt bzw. entwärmt werden.

Bei dem Kühlmittel kann es sich um ein gasförmiges Kühlmittel handeln, wie beispielsweise Luft, das durch einen Lüfter in dem Kühlpfad 7 bewegt wird. Zur Führung des Kühlmittels können beispielsweise ein Kühlkanal oder Luftleitbleche zum Einsatz kommen. Der Kühlpfad kann dann einen Eintritt und einen Austritt aufweisen, an dem das gasförmige Kühlmittel eintritt bzw. austritt. Alternativ kann das Kühlmittel auch eine Flüssigkeit wie beispielsweise Wasser sein. In diesem Fall ist ein geschlossener Kühlkreislauf vorteilhaft, der neben dem Kühlpfad 7 einen Wärmetauscher aufweist, mit dessen Hilfe dem erwärmten Kühlmittel Wärme entzogen wird. Für eine Kühlung mit einem flüssigen Kühlmittel hat sich ein geschlossener Kühlkreislauf, beispielweise ein geschlossener Kühlkanal, als vorteilhaft erwiesen. Dadurch kann das Kühlmittel wirkungsvoll genutzt werden. Darüber hinaus ist der Platzbedarf mit der Flüssigkeitskühlung im Vergleich zu einer Kühlung mit einem gasförmigen Kühlmittel besonders gering. Durch die Vielzahl der Submodule 1 ergibt sich aufgrund der verteilt im Stromrichter anfallenden Wärme auch nur ein geringerer Platzbedarf für die Vielzahl der zu kühlenden Komponenten, so dass der modulare Multilevel-Stromrichter besonders leicht und kompakt aufgebaut werden kann.

Zusammenfassend betrifft die Erfindung ein Submodul für einen modularen Multilevel-Stromrichter, wobei das Submodul zwei Kondensatoren, zwei Widerstände und sechs Halbleiterschalter aufweist, wobei die zwei Kondensatoren in Reihe angeordnet sind, wobei jeweils elektrisch parallel zu den Kondensatoren zwei der Halbleiterschalter in Reihe angeordnet sind, wobei ein Verbindungspunkt in der Verbindung zwischen den zwei in Reihe angeordneten Halbleiterschaltern jeweils einen Anschluss des Submoduls bildet. Zur Verbesserung hinsichtlich seines Bremsstellers eines aus Submodulen aufgebauten modularen Multilevel-Stromrichters wird vorgeschlagen, dass jeweils zu den Kondensatoren elektrisch parallel eine Reihenschaltung von einem der Widerstände und einem der Halbleiterschalter angeordnet ist. Ferner betrifft die Erfindung einen modularer Multilevel-Stromrichter, wobei der modulare Multilevel Stromrichter Gleichspannungsanschlüsse aufweist, wobei zwischen den Gleichspannungsanschlüssen eine Vielzahl von derartigen Submodulen elektrisch in Reihe angeordnet sind. Die Erfindung betrifft weiter ein Verfahren zum Betreiben eines derartigen Submoduls oder eines derartigen modularen Multilevel-Stromrichters, wobei zur Umwandlung von elektrischer Energie in Wärme mindestens einer der zwei in einer Reihenschaltung mit einem der Widerstände angeordneten Halbleiterschalter getaktet oder geschaltet wird.

## Patentansprüche

1. Submodul (1) für einen modularen Multilevel-Stromrichter (2), wobei das Submodul (1)
- zwei Kondensatoren (3),
- zwei Widerstände (4) und
- sechs Halbleiterschalter (5,51,52,53,54,55,56) aufweist, wobei die zwei Kondensatoren (3) in Reihe angeordnet sind, wobei jeweils elektrisch parallel zu den Kondensatoren (3) zwei der Halbleiterschalter (5,51,52,53,54) in Reihe angeordnet sind, wobei ein Verbindungspunkt (60) in der Verbindung zwischen den zwei in Reihe angeordneten Halbleiterschaltern (5) jeweils einen Anschluss (11) des Submoduls (1) bildet, **dadurch gekennzeich**- **net**, dass jeweils zu den Kondensatoren (3) elektrisch parallel eine Reihenschaltung von einem der Widerstände (4) und einem der Halbleiterschalter (5,55,56) angeordnet ist.

2. Submodul (1) nach Anspruch 1, wobei die zwei in einer Reihenschaltung mit einem der Widerstände (4) angeordneten Halbleiterschalter (5,55,56) als ein Halbbrückenmodul (58) ausgebildet sind, wobei der Phasenanschluss (59) des Halbbrückenmoduls (58) mit einem weiteren Verbindungspunkt (61) in der Verbindung zwischen den zwei Kondensatoren (3) verbunden ist.

3. Submodul (1) nach einem der Ansprüche 1 oder 2, wobei die in Reihe und gleichzeitig parallel zum Kondensator (3) angeordneten Halbleiterschalter (5,51,52,53,54) jeweils durch ein weiteres Halbbrückenmodul (68) gebildet werden, wobei der Phasenanschluss (69) des weiteren Halbbrückenmoduls (68) den Anschluss (11) des Submoduls (1) bildet.

4. Submodul (1) nach einem der Ansprüche 1 bis 3, wobei das Submodul (1) einen Kühlpfad (7) aufweist, der sich entlang der Halbleiterschalter (5) und der Widerstände (4) erstreckt.

5. Modularer Multilevel-Stromrichter (2), wobei der modulare Multilevel Stromrichter (2) Gleichspannungsanschlüsse (24) aufweist, wobei zwischen den Gleichspannungsanschlüssen (24) eine Vielzahl von Submodulen (1) nach einem der Ansprüche 1 bis 4 elektrisch in Reihe angeordnet sind.

6. Modularer Multilevel-Stromrichter (2) nach Anspruch 5, wobei der modulare Multilevel-Stromrichter (2) mindestens ein Phasenmodul (21) aufweist, wobei das Phasenmodul (21) zwei in Reihe angeordnete Konverterarme (22) umfasst, wobei die Konverterarme (22) jeweils eine Reihenschaltung einer Vielzahl der Submodule (1) aufweisen, wobei die Verbindung zwischen den zwei Konverterarmen (22) mit einem Phasenanschluss (23) des modularen Multilevel-Stromrichters (2) elektrisch leitend verbunden ist.

7. Modularer Multilevel-Stromrichter (2) nach Anspruch 5 oder 6, wobei der modulare Multilevel-Stromrichter (2) genau drei Phasenmodule (21) aufweist.

8. Verfahren zum Betreiben eines Submoduls (1) nach einem der Ansprüche 1 bis 4 oder eines modularen Multilevel-Stromrichters (2) nach einem der Ansprüche 5 bis 7, wobei zur Umwandlung von elektrischer Energie in Wärme mindestens einer der zwei in einer Reihenschaltung mit einem der Widerstände (4) angeordneten Halbleiterschalter (5,55,56) getaktet oder geschaltet wird.

9. Verfahren nach Anspruch 8, wobei die zwei in einer Reihenschaltung mit einem der Widerstände (4) angeordneten Halbleiterschalter (5,55,56) derart getaktet oder geschaltet werden, dass sich die an den Kondensatoren (4) anliegenden Spannungen annähern oder identisch sind.
